# EUROPEAN PATENT APPLICATION

(11) **EP 4 443 748 A1**
(43) Date of publication of application: **09.10.2024**
(21) Application number: 22899733.4
(22) Date of filing: 25.02.2022
(51) Int. Cl.: H03M 1/12, H03M 1/06

(54) **INPUT BUFFER APPARATUS, ELECTRONIC DEVICE AND CIRCUIT BOARD ASSEMBLY**

(30) Priority: 01.12.2021 CN 202111456307
(71) Applicant: SANECHIPS TECHNOLOGY CO., LTD., Shenzhen, Guangdong 518055 (CN)
(72) Inventor: LIU, Haizhu, Shenzhen, Guangdong 518057 (CN); CAI, Renhuan, Shenzhen, Guangdong 518057 (CN)
(74) Representative: Ipsilon
(86) International application number: PCT/CN2022/078104
(87) International publication number: WO 2023/097910

(57) **Abstract**

The present application relates to the technical field of electronic circuits, and discloses an input buffer apparatus, an electronic device and a circuit board assembly. The input buffer apparatus includes two input buffer circuits and an amplifier; where the two input buffer circuits are a first input buffer circuit and a second input buffer circuit, respectively, which have the same structure type, and each buffer circuit has two differential inputs, two differential outputs and a common mode feedback input; the two differential inputs of the second input buffer circuit are short circuited at a position serving as the common mode feedback input, and the two differential outputs are short circuited at a position forming a common mode output; and the common mode output of the second input buffer circuit is connected to an inverting input of the amplifier, a non-inverting input of the amplifier is configured to receive a common mode reference voltage, and an output of the amplifier is connected to the common mode feedback input of the second input buffer circuit and connected to the common mode feedback input of the first input buffer circuit.

## Description

### CROSS-REFERENCE TO RELATED APPLICATIONS

The present application is based on and claims the priority from Chinese patent application No. 202111456307.9 filed on December 1, 2021, the entire disclosure of which is incorporated herein by reference.

### TECHNICAL FIELD

Embodiments of the present application relate to the technical field of electronic circuits, and particularly relate to an input buffer apparatus, an electronic device and a circuit board assembly.

### BACKGROUND

In modern electronic systems, the input buffer is one of the essential modules in the integrated circuit. The input buffer is used for isolating an input network from a sampling network, thereby reducing the influence of kickback of the sampling network on input signals, and improving linearity of the sampling network, while having notable advantages such as a strong driving capability, an impedance conversion function, and the like. Nowadays, in radio frequency communication systems with an increasing requirement on bandwidth of the input signals, higher requirement has also been put forward for the input of the analog to digital converter (ADC). In a high-speed and high-precision ADC, an input buffer with a stable output common mode and a high bandwidth is indispensable.

However, most conventional input buffers cannot implement a stable output common mode while ensuring a high bandwidth.

### SUMMARY

An embodiment of the present application provides an input buffer apparatus, including: two input buffer circuits and an amplifier; wherein the two input buffer circuits have the same structure type, and each of the two input buffer circuits has two differential inputs, two differential outputs and a common mode feedback input; the two input buffer circuits are a first input buffer circuit and a second input buffer circuit, respectively; the two differential inputs of the second input buffer circuit are short circuited at a position serving as the common mode feedback input, and the two differential outputs of the second input buffer circuit are short circuited at a position forming a common mode output; and the common mode output of the second input buffer circuit is connected to an inverting input of the amplifier, a non-inverting input of the amplifier is configured to receive a common mode reference voltage, and an output of the amplifier is connected to the common mode feedback input of the second input buffer circuit and connected to the common mode feedback input of the first input buffer circuit.

An embodiment of the present application provides an electronic device including the input buffer apparatus described above.

An embodiment of the present application provides a circuit board assembly including the input buffer apparatus described above.

### BRIEF DESCRIPTION OF DRAWINGS

FIG. 1 is a schematic structural diagram of an input buffer apparatus according to an embodiment of the present application;
FIG. 2 is a schematic structural diagram of input buffer circuits in a conventional source follower structure;
FIG. 3 is a schematic structural diagram of a first input buffer circuit according to an embodiment of the present application;
FIG. 4 is a schematic structural diagram of a second input buffer circuit according to an embodiment of the present application;
FIG. 5 is a schematic structural diagram of an amplifier according to an embodiment of the present application;
FIG. 6 is a schematic structural diagram of a first input buffer circuit according to another embodiment of the present application; and
FIG. 7 is a schematic structural diagram of a second input buffer circuit according to another embodiment of the present application.

### DETAIL DESCRIPTION OF EMBODIMENTS

An object of embodiments of the present application is to provide an input buffer apparatus, an electronic device, and a circuit board assembly for enabling stable common mode output of input buffer circuits while avoiding reduction in the bandwidth of the input buffer circuits.

To make the objects, technical solutions and advantages of the embodiments of the present application clearer, embodiments of the present application will be described in detail below with reference to the accompanying drawings. However, it will be appreciated by those of ordinary skill in the art that, although numerous technical details are set forth in various embodiments of the present application to provide a better understanding of the present application, the technical solutions claimed in the present application can be implemented even without these technical details or based on various changes and modifications based on the following embodiments. The following embodiments are divided for convenience of description, and should not constitute any limitation to the specific implementation of the present application, and the embodiments may be mutually incorporated and referred to without contradiction.

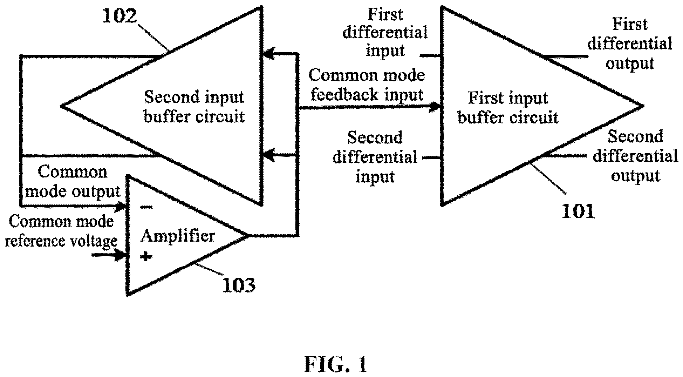

One embodiment of the present application relates to an input buffer apparatus having a circuit diagram as shown in FIG. 1.

In this embodiment, the input buffer apparatus includes: two input buffer circuits and an amplifier; where the two input buffer circuits have the same structure type, and of the two input buffer circuits has two differential inputs, two differential outputs and a common mode feedback input; the two input buffer circuits are a first input buffer circuit and a second input buffer circuit, respectively; the two differential inputs of the second input buffer circuit are short circuited at a position serving as the common mode feedback input, and the two differential outputs of the second input buffer circuit are short circuited at a position forming a common mode output; and the common mode output of the second input buffer circuit is connected to an inverting input of the amplifier, a non-inverting input of the amplifier is configured to receive a common mode reference voltage, and an output of the amplifier is connected to the common mode feedback input of the second input buffer circuit and connected to the common mode feedback input of the first input buffer circuit.

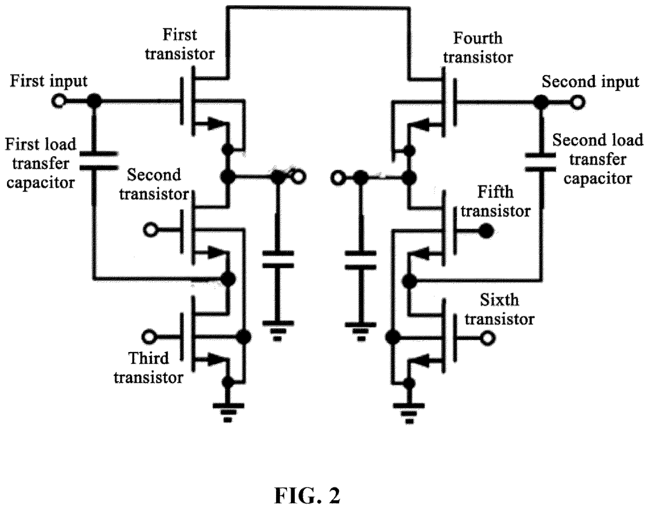

FIG. 2 shows input buffer circuits in a conventional source follower structure. The first input and the second input shown in FIG. 2 are current source bias voltages of the input buffer for ensuring a stable operating current. FIG. 2 further shows a first load transfer capacitor and a second load transfer capacitor, which can compensate for changes in the current of the second transistor and the fifth transistor, and improve the linearity of the circuit. However, there are several significant disadvantages associated with such input buffer circuits in the conventional source follower structure.

First, since the first transistor and the fourth transistor are directly connected to a power supply, a voltage difference Vds across two ends of the first transistor and the fourth transistor is not constant, and the modulation of Vds will cause deterioration of the linearity; second, since an output resistance ro =1/gm and to obtain a sufficiently high bandwidth in high bandwidth applications, ro can be reduced only by increasing gm, while gm can be increased only by increasing the operating current under the condition of an unchanged overdrive voltage, resulting in relatively high power consumption; and third, the common mode output voltage varies with the process, voltage, and temperature (PVT for short) conditions, while the common mode detection circuit generally adopts a relatively large resistor to obtain the common mode, which often introduces a relatively large parasitic capacitance at an output node, resulting in reduction of the circuit bandwidth.

The implementation details of the input buffer apparatus in this embodiment will be specifically described below, and the following description is provided merely for facilitating understanding of the implementation details of the solution, and is not necessary for implementing the solution. As shown in FIG. 1, the input buffer apparatus may include: a first input buffer circuit 101, a second input buffer circuit 102, and an amplifier 103. In practice, the first input buffer circuit shown in FIG. 1 may serve as a main input buffer, and as an input/output module for high frequency signals; and in practice, the second input buffer circuit shown in FIG. 1 may serve as a replica input buffer.

The first input buffer circuit 101 and the second input buffer circuit 102 have the same structure type. The first input buffer circuit 101 and the second input buffer circuit 102 each have two differential inputs, two differential outputs and a common mode feedback input. The first differential input and the second differential input shown in FIG. 1 are the two differential inputs of the first input buffer circuit 101, and the first differential output and the second differential output provide output voltages of two common mode outputs of the first input buffer circuit 101.

In the second input buffer circuit 102, the two differential inputs are short circuited at a position also serving as the common mode feedback input. The two differential outputs of the second input buffer circuit 102 are also short circuited at a position forming a common mode output. The common mode output of the second input buffer circuit 102 shown in FIG. 1 is connected to an inverting input of the amplifier 103.

A non-inverting input of the amplifier 103 is configured to receive a common mode reference voltage, as shown in FIG. 1. The output of the amplifier 103 is connected to the common mode feedback input of the second input buffer circuit 102 and connected to the common mode feedback input of the first input buffer circuit 101. The second input buffer circuit 102 and the amplifier 103 form a common mode feedback (CMFB) loop, so that the common mode output of the first input buffer circuit 101 and the second input buffer circuit 102 under PVT can be stabilized at a common mode reference voltage.

In one example, each of the input buffer circuits may include four input transistors, i.e., a first input transistor, a second input transistor, a third input transistor and a fourth input transistor, each of which has a first end, a second end, and a third end. Each input transistor may be a triode or a field effect transistor. When the input transistor is a field effect transistor, the first end is a source, the second end is a drain, and the third end is a gate; and when the input transistor is a triode, the first end is an emitter, the second end is a collector, and the third end is a base.

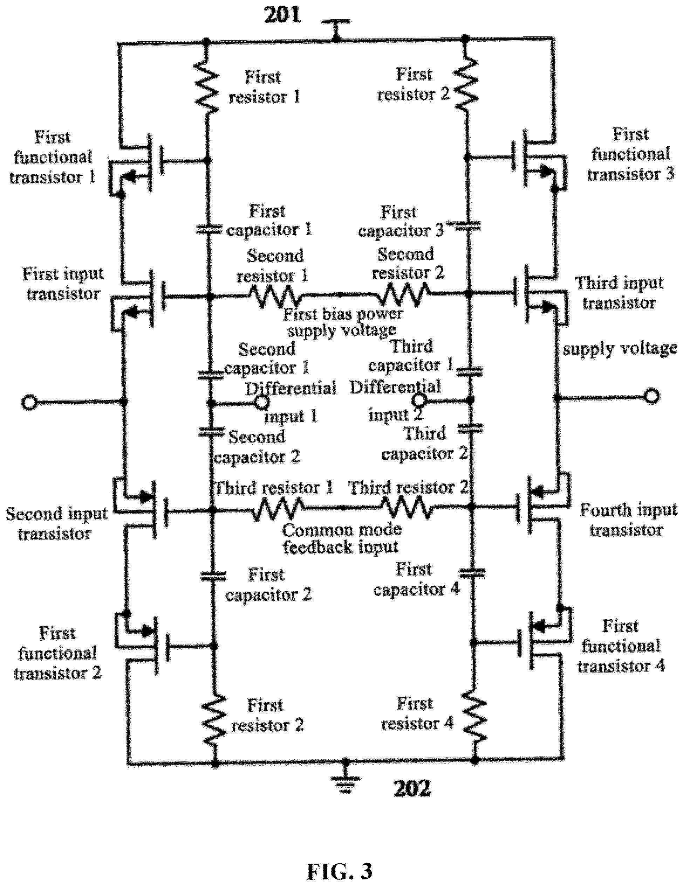

Next, the input buffer apparatus involved in this embodiment will be described below by taking the first input buffer circuit having the circuit structure shown in FIG. 3 as an example. In FIG. 3, the first end of the first input transistor is connected to the first end of the second input transistor, and the first end of the third input transistor is connected to the first end of the fourth input transistor; the second end of each input transistor is connected to the first end of the first functional transistor in the functional circuit corresponding to said input transistor; and the first input transistor and the third input transistor are both connected to a first voltage terminal 201, while the second input transistor and the fourth input transistor are both connected to a second voltage terminal 202. Further, a voltage (which may be understood as a first voltage) provided by the first voltage terminal is higher than a voltage (which may be understood as a second voltage) provided by the second voltage terminal. In FIG. 3, the voltage terminal 201 is a power terminal, and the voltage terminal 302 is a ground terminal.

A schematic circuit structure of the first input buffer circuit may be as shown in FIG. 3. In the first input buffer circuit shown in FIG. 3: two second resistors (shown as a second resistor 1 and a second resistor 2 in the figure) are connected in series between the third end of the first input transistor and the third end of the third input transistor. A connection point between the two second resistors is connected to a first bias power supply. Two third resistors (shown as a third resistor 1 and a third resistor 2 in the figure) are connected in series between the third end of the second input transistor and the third end of the fourth input transistor. A connection point between the two third resistors serves as the common mode feedback input of the first input buffer circuit. Two second capacitors are connected in series between the third end of the first input transistor and the third end of the second input transistor. A connection point between the two second capacitors serves as one of the differential inputs (shown as a differential input 1 in the figure) of the first input buffer circuit. Two third capacitors are connected in series between the third end of the third input transistor and the third end of the fourth input transistor. A connection point between the two third capacitors serves as the other differential input (shown as a differential input 2 in the figure) of the first input buffer circuit.

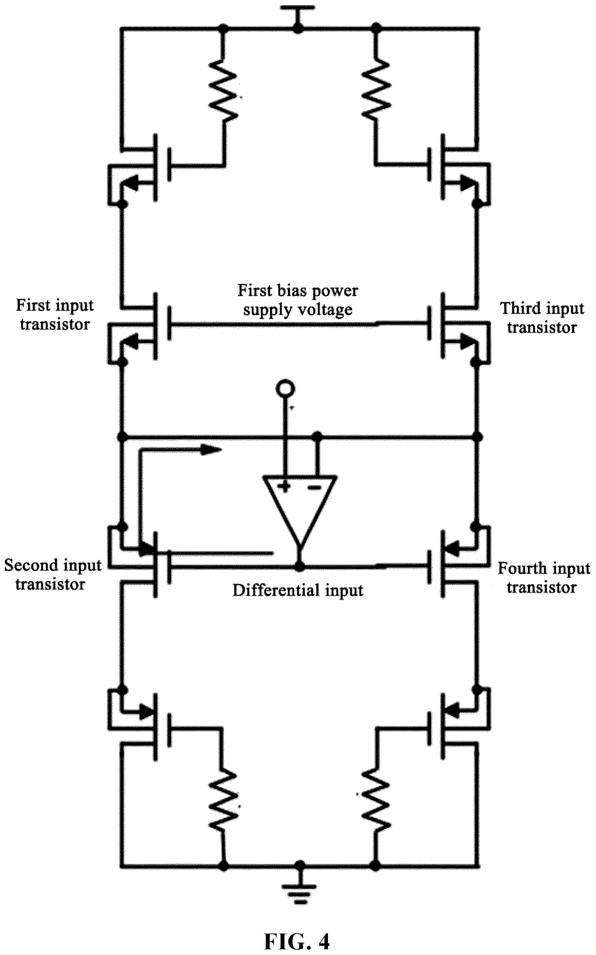

In the second input buffer circuit shown in FIG. 4: the third end of the first input transistor and the third end of the third input transistor are short circuited at a point connected to the first bias power supply; and the third end of the second input transistor and the third end of the fourth input transistor serve as the two differential inputs of the second input buffer circuit.

It should be noted that the input buffer circuits in the input buffer apparatus may adopt a push-pull structure. In an input buffer circuit having such a structure, the output resistance ro=l/(gmN+gmP), and gmN is typically equal to gmP. Therefore, under the same condition, the buffer circuit adopting the push-pull structure can obtain an approximately doubled bandwidth compared with the conventional circuit. In other words, with the same realized bandwidth, the input buffer circuit adopting the push-pull structure can reduce the power consumption by about 50%.

In addition to the push-pull structure, the input buffer circuits in the input buffer apparatus according to this embodiment may also adopt a source follower structure.

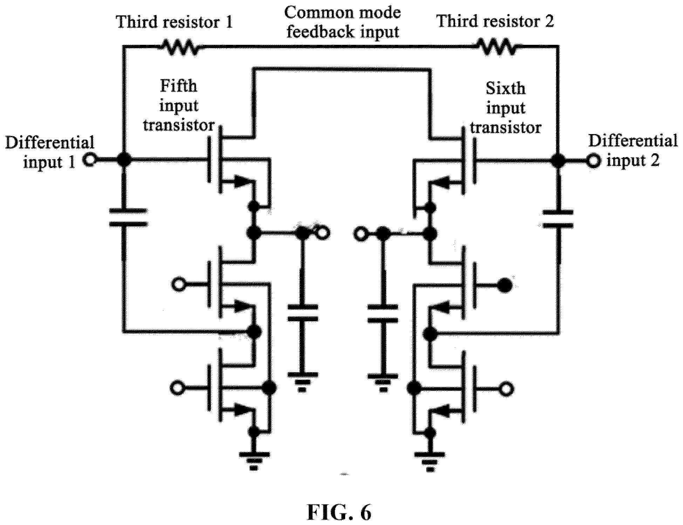

In another example, each of the input buffer circuits may include two input transistors, i.e., a fifth input transistor and a sixth input transistor, respectively. The first input buffer circuit has a circuit structure as shown in FIG. 6. In the first input buffer circuit, two second resistors (not shown in the figure) are connected in series between the third end of the fifth input transistor and the third end of the sixth input transistor, and a connection point between the two second resistors is connected to a first bias power supply (not shown in the figure); two third resistor are connected in series between the third end of the fifth input transistor and the third end of the sixth input transistor, and a connection point between the two third resistors serves as the common mode feedback input of the first input buffer circuit; and the third end of the fifth input transistor serves as one of the differential inputs (shown as a differential input 1 in FIG. 6) of the first input buffer circuit, while the third end of the sixth input transistor serves as the other differential input (shown as a differential input 2 in FIG. 6) of the first input buffer circuit.

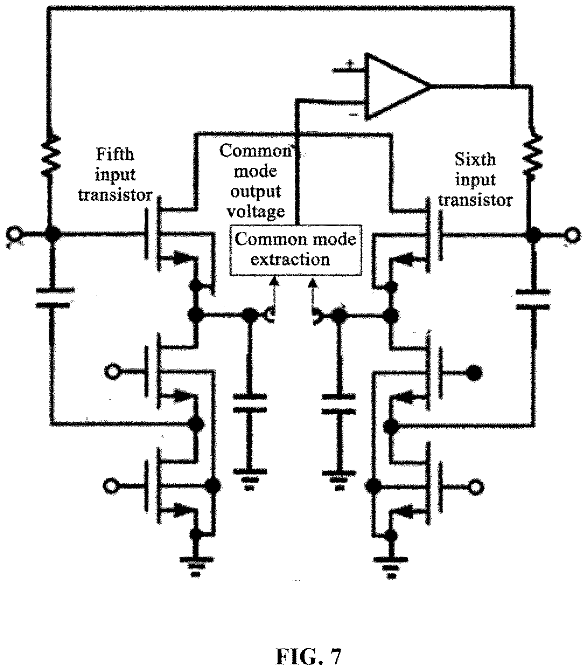

In the second input buffer circuit shown in FIG. 7: the third end of the fifth input transistor and the third end of the sixth input transistor are short circuited at a point connected to the first bias power supply (not shown in the figure); and the third end of the fifth input transistor and the third end of the sixth input transistor serve as the two differential inputs of the second input buffer circuit. It should be noted that in the second input buffer circuit shown in FIG. 7, a module for extracting the common mode (shown as the common mode extraction module in FIG. 7) may be provided between the two differential outputs, so that inputs of the two differential outputs would be processed by the module to form a common mode output voltage which is then input to the inverting input of the amplifier. In practical implementations, the module for extracting the common mode here may be an electronic device with the function of extracting the common mode, including a resistor or an operational amplifier.

In one example, the second input buffer circuit has a size smaller than the first input buffer circuit; and the smaller the size of the second input buffer circuit, the lower the power consumption. The size of the second input buffer circuit may be scaled to 1/N (N>1) of the size of the first input buffer circuit. In practical implementations, N may not be a fixed value, but may change as needed. For example, N may take a larger value if the requirement is more focused on low power consumption; and N may be set to a smaller value if the requirement is more focused on the accuracy of the output common mode.

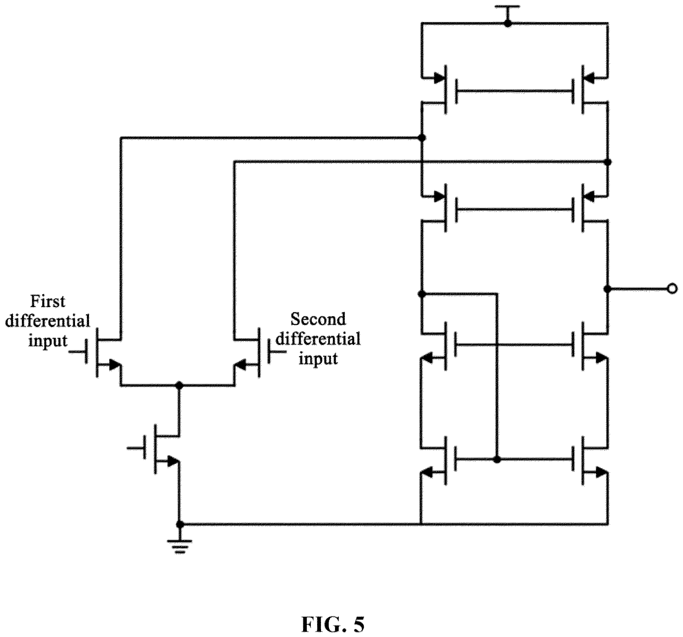

It should be noted that the amplifier in this embodiment may adopt a folded-cascode structure as shown in FIG. 5, which can achieve a stable CMFB loop more easily while ensuring the loop gain. The amplifier circuit provides a gain for the CMFB loop, and ensures a phase margin greater than 45 degrees in practical implementations, thereby ensuring a stable CMFB loop.

It should be understood by those skilled in the art that the amplifier in the present application is not limited to the structure shown in FIG. 5, and any amplifier having another structure capable of performing signal amplification and satisfying the requirements on the input buffer apparatus in this embodiment is also applicable to this embodiment.

In this embodiment, the second input buffer circuit and the amplifier form a common mode feedback loop, which enables stable common mode output of the second input buffer circuit. Further, since the two input buffer circuits have the same structure type, the first input buffer circuit can also have stable common mode output after the common mode feedback from the common mode feedback loop is provided to the first input buffer circuit. Compared with the conventional technical means for providing the common mode feedback for the buffer circuit by connecting a common mode detection circuit at the output of the buffer circuit, this embodiment can implement common mode detection of the input buffer circuit, while avoiding introduction of parasitic capacitance at the output of the input buffer circuit which capacitance may reduce the bandwidth of the circuit.

Another embodiment of the present application relates to an input buffer apparatus. The input buffer apparatus of this embodiment involves an improvement based on the input buffer apparatus according to the previous embodiment.

In this embodiment, the input buffer apparatus includes: two input buffer circuits and an amplifier; where the two input buffer circuits have the same structure type, and each of the two input buffer circuits has two differential inputs, two differential outputs and a common mode feedback input; the two input buffer circuits are a first input buffer circuit and a second input buffer circuit, respectively; the two differential inputs of the second input buffer circuit are short circuited at a position serving as the common mode feedback input, and the two differential outputs of the second input buffer circuit are short circuited at a position forming a common mode output; and the common mode output of the second input buffer circuit is connected to an inverting input of the amplifier, a non-inverting input of the amplifier is configured to receive a common mode reference voltage, and an output of the amplifier is connected to the common mode feedback input of the second input buffer circuit and connected to the common mode feedback input of the first input buffer circuit.

In this embodiment, each input transistor of each input buffer circuit is connected to a voltage terminal corresponding to the input transistor through a functional circuit. A schematic diagram of the input buffer circuits involved in this embodiment is shown in FIG. 3.

Each functional circuit involved in this embodiment includes a first functional transistor, a first capacitor and a first resistor. A first input transistor is connected to a voltage terminal 201 through the functional circuit composed of a first functional transistor 1, a first capacitor 1 and a first resistor 1; a third input transistor is connected to the voltage terminal 201 through the functional circuit composed of a first functional transistor 3, a first capacitor 3 and a first resistor 3; a second input transistor is connected to a voltage terminal 202 through the functional circuit composed of a first functional transistor 2, a first capacitor 2 and a first resistor 2; and a fourth input transistor is connected to the voltage terminal 202 through the functional circuit composed of a first functional transistor 4, a first capacitor 4 and a first resistor 4.

A first end of the first functional transistor is connected to a second end of the input transistor, a second end of the first functional transistor is connected to the voltage terminal, and a third end of the first functional transistor is connected to a third end of the input transistor through the first capacitor and connected to the voltage terminal through the first resistor. The first functional transistor and the input transistor are both field effect transistors, in which the first end is a source, the second end is a drain, and the third end is a gate; or, the first functional transistor and the input transistor are both triodes, in which the first end is an emitter, the second end is a collector, and the third end is a base.

In one example, each of the input buffer circuits may include four input transistors, i.e., a first input transistor, a second input transistor, a third input transistor and a fourth input transistor, each of which has a first end, a second end, and a third end. In FIG. 3, the first end of the first input transistor is connected to the first end of the second input transistor, and the first end of the third input transistor is connected to the first end of the fourth input transistor; the second end of each input transistor is connected to the first end of the first functional transistor in the functional circuit corresponding to the input transistor; and the voltage terminal 201 corresponding to the first input transistor and the third input transistor provides a first voltage, the voltage terminal 202 corresponding to the second input transistor and the fourth input transistor provides a second voltage, and the first voltage is higher than the second voltage. In FIG. 3, the voltage terminal 201 is a power terminal, and the voltage terminal 202 is a ground terminal.

A schematic circuit structure of the first input buffer circuit may be also as shown in FIG. 3. In the first input buffer circuit shown in FIG. 3: two second resistors are connected in series between the third end of the first input transistor and the third end of the third input transistor. A connection point between the two second resistors is connected to a first bias power supply. Two third resistors are connected in series between the third end of the second input transistor and the third end of the fourth input transistor. A connection point between the two third resistors serves as a common mode feedback input of the first input buffer circuit. Two second capacitors are connected in series between the third end of the first input transistor and the third end of the second input transistor. A connection point between the two second capacitors serves as one of the differential inputs of the first input buffer circuit. Two third capacitors are connected in series between the third end of the third input transistor and the third end of the fourth input transistor. A connection point between the two third capacitors serves as the other differential input of the first input buffer circuit.

In the second input buffer circuit shown in FIG. 4: the third end of the first input transistor and the third end of the third input transistor are short circuited at a point connected to the first bias power supply; and the third end of the second input transistor and the third end of the fourth input transistor serve as the two differential inputs of the second input buffer circuit.

It should be noted that the input buffer circuits in the input buffer apparatus according to this embodiment may adopt a push-pull structure. Under the same conditions, such a buffer circuit can obtain an approximately doubled bandwidth compared with the conventional circuit. In other words, under the same embodiment bandwidth, the power consumption can be reduced by about 50%.

In this embodiment, the second input buffer circuit and the amplifier form a common mode feedback loop, which enables stable common mode output of the second input buffer circuit. Further, since the two input buffer circuits have the same structure type, the first input buffer circuit can also have stable common mode output after the common mode feedback from the common mode feedback loop is provided to the first input buffer circuit. Moreover, a bootstrap capacitor in the functional circuit can enable a substantially unchanged Vds of the input transistor, thereby improving the linearity of the input buffer circuit. The present application can implement common mode detection of the input buffer circuit, while avoiding introduction of parasitic capacitance at the output of the input buffer circuit which may reduce the bandwidth of the circuit, and ensuring the linearity of the input buffer apparatus.

It should be noted that units which are not so closely related to solving the technical problem proposed by the present application are not introduced in the embodiments of the present application, but this does not indicate that no other unit is present in the embodiments.

One embodiment of the present application relates to an electronic device including the input buffer apparatus described above. The electronic device according to this embodiment may be an ADC integrated with the input buffer apparatus described above, or an independent chip including the input buffer apparatus described above.

In the electronic device of this embodiment, the second input buffer circuit and the amplifier form a common mode feedback loop, which enables stable common mode output of the second input buffer circuit. Further, since the two input buffer circuits have the same structure type, the first input buffer circuit can also have stable common mode output after the common mode feedback from the common mode feedback loop is provided to the first input buffer circuit. Compared with the conventional technical means for providing a common mode feedback for the buffer circuit by connecting a common mode detection circuit at the output of the buffer circuit, this embodiment can implement common mode detection of the input buffer circuit, while avoiding introduction of parasitic capacitance at the output of the input buffer circuit which may reduce the bandwidth of the circuit.

Another embodiment of the present application relates to a circuit board assembly including the input buffer apparatus described above.

In the circuit board assembly of this embodiment, the second input buffer circuit and the amplifier form a common mode feedback loop, which enables stable common mode output of the second input buffer circuit. Further, since the two input buffer circuits have the same structure type, the first input buffer circuit can also have stable common mode output after the common mode feedback from the common mode feedback loop is provided to the first input buffer circuit. Compared with the conventional technical means for providing a common mode feedback for the buffer circuit by connecting a common mode detection circuit at the output of the buffer circuit, this embodiment can implement common mode detection of the input buffer circuit, while avoiding introduction of parasitic capacitance at the output of the input buffer circuit which may reduce the bandwidth of the circuit.

The above embodiments are provided to enable those of ordinary skill in the art to implement and use the present application, and modifications and variations may be made to the above embodiments by those of ordinary skill in the art without departing from the spirit of the present application. Therefore, the protection scope of the present application is not limited by the above embodiments, but by the broadest scope of the inventive features recited in the claims.

## Claims

1. An input buffer apparatus, comprising: two input buffer circuits and an amplifier;
wherein the two input buffer circuits have the same structure type, and each of the two input buffer circuits has two differential inputs, two differential outputs and a common mode feedback input; and the two input buffer circuits are a first input buffer circuit and a second input buffer circuit, respectively;
wherein the two differential inputs of the second input buffer circuit are short circuited at a position serving as the common mode feedback input, and the two differential outputs of the second input buffer circuit are short circuited at a position forming a common mode output; and
wherein the common mode output of the second input buffer circuit is connected to an inverting input of the amplifier, a non-inverting input of the amplifier is configured to receive a common mode reference voltage, and an output of the amplifier is connected to the common mode feedback input of the second input buffer circuit and connected to the common mode feedback input of the first input buffer circuit.

2. The input buffer apparatus according to claim 1, wherein each input transistor of the input buffer circuit is connected to a voltage terminal corresponding to the input transistor through a functional circuit;
wherein the functional circuit comprises a first functional transistor, a first capacitor and a first resistor;
wherein a first end of the first functional transistor is connected to a second end of the input transistor, a second end of the first functional transistor is connected to the voltage terminal, and a third end of the first functional transistor is connected to a third end of the input transistor through the first capacitor and connected to the voltage terminal through the first resistor; and
wherein the first functional transistor and the input transistor are both field effect transistors, in which the first end is a source, the second end is a drain, and the third end is a gate; or, the first functional transistor and the input transistor are both triodes, in which the first end is an emitter, the second end is a collector, and the third end is a base.

3. The input buffer apparatus according to claim 1 or 2, wherein the input buffer circuit employs a push-pull structure.

4. The input buffer apparatus according to claim 2, wherein each of the input buffer circuits comprises four input transistors each having a first end, a second end, and a third end;
wherein the four input transistors are a first input transistor, a second input transistor, a third input transistor and a fourth input transistor, respectively; the first end of the first input transistor is connected to the first end of the second input transistor, and the first end of the third input transistor is connected to the first end of the fourth input transistor; the second end of each input transistor is connected to the first end of the first functional transistor in the functional circuit corresponding to the input transistor; the voltage terminal corresponding to the first input transistor and the third input transistor provides a first voltage, the voltage terminal corresponding to the second input transistor and the fourth input transistor provides a second voltage, and the first voltage is higher than the second voltage;
wherein in the first input buffer circuit: two second resistors are connected in series between the third end of the first input transistor and the third end of the third input transistor, and a connection point between the two second resistors is connected to a first bias power supply; two third resistors are connected in series between the third end of the second input transistor and the third end of the fourth input transistor, and a connection point between the two third resistors serves as a common mode feedback input of the first input buffer circuit; and two second capacitors are connected in series between the third end of the first input transistor and the third end of the second input transistor, and a connection point between the two second capacitors serves as one of the differential inputs of the first input buffer circuit; two third capacitors are connected in series between the third end of the third input transistor and the third end of the fourth input transistor, and a connection point between the two third capacitors serves as the other differential input of the first input buffer circuit; and
wherein in the second input buffer circuit: the third end of the first input transistor and the third end of the third input transistor are short circuited at a point connected to the first bias power supply; and the third end of the second input transistor and the third end of the fourth input transistor serve as the two differential inputs of the second input buffer circuit.

5. The input buffer apparatus according to claim 1, wherein each of the input buffer circuits comprises four input transistors each having a first end, a second end, and a third end; wherein the input transistors are field effect transistors, the first end is a source, the second end is a drain, and the third end is a gate; or, the input transistors are triodes, the first end is an emitter, the second end is a collector, and the third end is a base;
wherein the four input transistors are a first input transistor, a second input transistor, a third input transistor and a fourth input transistor, respectively; the first end of the first input transistor is connected to the first end of the second input transistor, and the first end of the third input transistor is connected to the first end of the fourth input transistor; the second end of the first input transistor and the second end of the third input transistor are both connected to a first voltage terminal, the second end of the second input transistor and the second end of the fourth input transistor are both connected to a second voltage terminal, and the first voltage terminal provides a voltage higher than the second voltage terminal;
wherein in the first input buffer circuit: two second resistors are connected in series between the third end of the first input transistor and the third end of the third input transistor, and a connection point between the two second resistors is connected to a first bias power supply; two third resistors are connected in series between the third end of the second input transistor and the third end of the fourth input transistor, and a connection point between the two third resistors serves as a common mode feedback input of the first input buffer circuit; and two second capacitors are connected in series between the third end of the first input transistor and the third end of the second input transistor, and a connection point between the two second capacitors serves as one of the differential inputs of the first input buffer circuit; two third capacitors are connected in series between the third end of the third input transistor and the third end of the fourth input transistor, and a connection point between the two third capacitors serves as the other differential input of the first input buffer circuit; and
wherein in the second input buffer circuit: the third end of the first input transistor and the third end of the third input transistor are short circuited at a point connected to the first bias power supply; and the third end of the second input transistor and the third end of the fourth input transistor serve as the two differential inputs of the second input buffer circuit.

6. The input buffer apparatus according to claim 1 or 5, wherein the input buffer circuit employs a source follower structure.

7. The input buffer apparatus according to claim 1, wherein each of the input buffer circuits comprises two input transistors, which are a fifth input transistor and a sixth input transistor, respectively;
wherein in the first input buffer circuit: two second resistors are connected in series between a third end of the fifth input transistor and a third end of the sixth input transistor, and a connection point between the two second resistors is connected to a first bias power supply; two third resistor are connected in series between the third end of the fifth input transistor and the third end of the sixth input transistor, and a connection point between the two third resistors serves as a common mode feedback input of the first input buffer circuit; the third end of the fifth input transistor serves as one of the differential inputs of the first input buffer circuit, and the third end of the sixth input transistor serves as the other differential input of the first input buffer circuit; and
wherein in the second input buffer circuit: the third end of the fifth input transistor and the third end of the sixth input transistor are short circuited at a point connected to the first bias power supply, and the third end of the fifth input transistor and the third end of the sixth input transistor serve as the two differential inputs of the second input buffer circuit.

8. The input buffer apparatus according to claim 1 or 7, wherein the second input buffer circuit has a size smaller than the first input buffer circuit; and wherein the smaller the size of the second input buffer circuit, the lower the power consumption.

9. An electronic device, comprising the input buffer apparatus according to any one of claims 1 to 8.

10. A circuit board assembly, comprising the input buffer apparatus according to any one of claims 1 to 8.
